# EUROPEAN PATENT SPECIFICATION

(11) **EP 4 044 214 B1**
(45) Date of publication and mention of the grant of the patent: **12.08.2026**
(21) Application number: 19952365.5
(22) Date of filing: 12.11.2019
(51) Int. Cl.: H10D 89/60, H10W 90/00

(54) **SEMICONDUCTOR DEVICE**
HALBLEITERBAUELEMENT
DISPOSITIF À SEMI-CONDUCTEUR

(43) Date of publication of application: 17.08.2022
(73) Proprietor: Huawei Technologies Co., Ltd., Shenzhen, Guangdong 518129 (CN)
(72) Inventor: HUANG, Ray, Shenzhen, Guangdong 518129 (CN); XU, Jeffrey Junhao, Shenzhen, Guangdong 518129 (CN); ZHANG, Rui, Shenzhen, Guangdong 518129 (CN)
(74) Representative: Goddar, Heinz J.
(86) International application number: PCT/CN2019/117587
(87) International publication number: WO 2021/092764

(56) References cited:
- CN-A- 101 207 118
- CN-A- 101 834 153
- CN-A- 104 157 650
- CN-A- 109 411 465
- US-A1- 2004 161 885
- US-A1- 2009 256 180
- US-A1- 2018 323 138
- US-A1- 2019 237 459
- US-B2- 6 559 485

## Description

### TECHNICAL FIELD

This application relates to the semiconductor field, and in particular, to a semiconductor device.

### BACKGROUND

During chip manufacturing, a wafer undergoes processes such as cleaning, film formation, etching, and diffusion/ion implantation to form a circuit on a substrate. Then, the wafer is cut into a die, and is further packaged to form a chip product. A conductor such as a metal wire or polysilicon in the wafer collects charges like an "antenna". This increases electric potential of the conductor. The longer the "antenna" is, the more charges are collected, and the higher the electric potential is. High electric potential on the conductor may break down a thin gate oxide layer in a metal oxide semiconductor (MOS) device, and therefore the circuit fails. The foregoing phenomenon is an "antenna effect".

Both of wafer cleaning and plasma etching may result in the antenna effect. A purpose of cleaning the wafer is to remove dummy particles, organic matter, a metal, and a primary oxide layer on a surface of the wafer. This avoids a short circuit or circuit breaking inside the wafer, and improves a yield rate of the die. Wet clean is a mainstream technology for the wafer cleaning, and mainly includes cleaning the organic matter on the surface of the wafer and cleaning inorganic residue. However, in the cleaning process, pure water in contact with the wafer may generate static electricity. This takes away positive charges and leaves negative charges (electrons) on the surface of the wafer. In addition, in a deep submicron integrated circuit processing process, plasma etching based on a plasma technology is usually performed on the wafer. In a process of the plasma etching, free charges are generated on the surface of the wafer. When the conductor (such as a metal or polysilicon) is etched, an exposed surface of the conductor collects the free charges, and a quantity of accumulated charges is directly proportional to an area of the conductor exposed to a plasma beam. When the charges are accumulated on a gate, a tunneling current is formed at the gate oxide layer under polycrystalline silicon to discharge the charges. If a large quantity of the charges are discharged, the gate oxide layer is damaged. As a result, reliability and a service life of a device and even an entire chip are reduced.

In the foregoing plasma etching and wet cleaning processes, the charges may be generated on the surface of the wafer. This damages a circuit on the wafer, and reduces a yield rate and reliability of the wafer.
US 2004/161885 A1 discloses a semiconductor device having a junction diode and a fabricating method therefore that prevents deterioration of the gate insulating layer during a plasma etching process required for wire formation. The semiconductor device includes a junction diode (a unidirectional or bi-directional junction diode) formed in the substrate at a predetermined distance apart from a gate wire of a transistor. The gate wire is coupled through an insulating layer to a metal wire, and the diode(s) are coupled to a dummy metal pattern formed proximal to the metal wire. In this manner, plasma charge generated during wire formation, is discharged into the semiconductor substrate through the junction diode, preventing accumulation of the plasma charge in the gate insulating layer of the device. Deterioration of the gate insulating layer is thereby avoided.
US 6 559 485 B2 discloses a transistor including a first gate electrode is formed on a substrate through a gate insulation film. An insulation film is formed on the transistor and the substrate. A plurality of first wirings are formed on the insulation film, spaced from each other by a first gap. A second wiring is formed, spaced from either of the first wiring by a second gap which is substantially equal to the first gap. Either of the first wirings is electrically connected to the first gate electrode, and the second wiring is electrically connected to the substrate.
US 2019/237459 A1 discloses a semiconductor device, a method for manufacturing a semiconductor device, and a plasma-induced damage (PID) protection device capable of, without increasing a chip area, releasing a large PID with high efficiency and protecting an element to be protected from the PID with higher accuracy. There are provided a protection metal-oxide-semiconductor field-effect transistor (MOSFET) that includes a drain connected to a gate electrode of a MOSFET to be protected and a grounded source and protects the MOSFET to be protected from a plasma-induced damage (PID), and a dummy antenna connected to a gate electrode of the protection MOSFET, the dummy antenna turning on the protection MOSFET prior to the MOSFET to be protected due to PID charge. The present disclosure can be applied to a semiconductor device.

### SUMMARY

The invention provides a semiconductor device of claim 1, a packaged chip of claim 11, and an electronic device of claim 12, to implement conduction of accumulated charges by using low-impedance resistance formed by a heavily-doped dummy source drain region and a lightly-doped P well in a dummy circuit. This improves a yield rate of the semiconductor device. Further embodiments of the invention are disclosed in the dependent claims.

According to a first aspect, an embodiment of this application provides a semiconductor device with a high yield rate, where the semiconductor device includes a substrate, an active circuit disposed on a side of the substrate, and a dummy circuit disposed on the same side of the substrate. The active circuit is a circuit having an actual circuit function in the semiconductor device, while the dummy circuit does not have the actual circuit function and is insulated from the active circuit. The dummy circuit includes a first dummy metal layer, a heavily-doped dummy source drain region disposed in the substrate, a first metal column connecting the first dummy metal layer and the dummy source drain region, and a lightly-doped P base (namely, a P trap). The P base is disposed at a location surrounding the dummy source drain region in the substrate. The first metal column may be a metal plug, for example, a cobalt plug or a copper plug. The semiconductor device may be a wafer, a die, a packaged chip, or a die in the packaged chip.

Because a doping density of the heavily-doped dummy source drain region is greater than a doping density of the P base, non-directional and low-impedance resistance is formed between the dummy source drain region and the P base. The resistance enables charges to flow from the substrate to the dummy source drain region through the P base, and then flow to the first dummy metal layer through the first metal column. Alternatively, the resistance may enable the charges to flow in a reverse direction, that is, flow from the first dummy metal layer to the dummy source drain region through the first metal column, and finally flow to the substrate through the P base. Because the charges may be transferred and flow in two channels in opposite directions, both positive charges and negative charges accumulated on metal conductors in the semiconductor device may be transferred, so that the metal conductors and the substrate are equipotential. Therefore, this can dredge the charges accumulated on the metal conductors, reduces damage caused by the charges to the circuit, and improves reliability and a yield rate of the semiconductor device.

In a possible implementation, a manufacturing process of the dummy circuit is the same as that of the active circuit, and both of the manufacturing processes are a FinFET manufacturing process or a planar device manufacturing process.

In a possible implementation, two different manufacturing processes may be implemented on the semiconductor device, for example, a manufacturing process for a dummy circuit of a FinFET and an active circuit of a planar device, or a manufacturing process for a dummy circuit of a planar device and an active circuit of a FinFET. The semiconductor device provided in this embodiment may be applicable to various processes and manufacturing processes, and supports different manufacturing processes on a same base.

In a possible implementation, the dummy circuit further includes a second dummy metal layer and a second metal column. The second dummy metal layer is disposed on a side that is of the first dummy metal layer and that is far away from the substrate, and the second metal column is connected to the first dummy metal layer and the second dummy metal layer. The second metal column may be one metal column or a plurality of metal columns. Adjacent dummy metal layers in the dummy circuit in this embodiment of this application are connected, so that the charges can be rapidly conducted in a direction perpendicular to the substrate. This further increases the yield rate of the semiconductor device and reduces a possibility of damage caused by the charges.

In a possible implementation, the second metal column is a metal copper via.

In a possible implementation, the dummy circuit further includes more dummy metal layers, and each dummy metal layer is connected to an adjacent dummy metal layer by using a metal column, or is connected to another dummy metal layer that is far away from the dummy metal layer by using the metal column. More dummy metal layers are connected, so that free charges can be better dredged.

In a possible implementation, a doping density of the heavily-doped dummy source drain region is 100 to 10000 times a doping density of the P base. Maintaining the doping density of the foregoing proportion may enable small resistance to be formed between the P base and the dummy source drain region.

In a possible implementation, a doping density of a dummy source drain region 232 is from 10¹⁹/*cm*³ to 10²²/*cm*³.

In a possible implementation, the dummy source drain region includes heavily-doped P-type silicon Si or heavily-doped P-type silicon-germanium SiGe. The heavily-doped P-type SiGe is used to facilitate transfer of free charges.

In a possible implementation, the dummy circuit further includes a third metal column disposed between the first dummy metal layer and a dummy gate region, and the dummy gate region disposed between the third metal column and the P base. The foregoing structure may be a planar device structure or a FinFET device structure.

In a possible implementation, the first metal column and the third metal column may be metal plugs, for example, cobalt plugs or copper plugs.

In a possible implementation, the dummy circuit further includes a gate metal layer disposed between the third metal column and the dummy gate region, and a source drain metal layer disposed between the first metal column and the dummy source drain region. The foregoing structure is a FinFET device structure.

In a possible implementation, the gate metal layer includes cobalt Co or titanium Ti, and the source drain metal layer includes Co or Ti.

According to a second aspect, an embodiment of this application provides a packaged chip, including a die, a plastic packaging material, and a connecting piece disposed on one side of the plastic packaging material, where the connecting piece is connected to the plastic packaging material and an external circuit, for example, another substrate or a PCB. The die may be a die in any possible implementation of the first aspect. The connecting piece may be a solder ball.

In a possible implementation, the packaged chip further includes a redistribution layer disposed on one side of the plastic packaging material, where the connecting piece connects the plastic packaging material and an external circuit.

According to a third aspect, an embodiment of this application provides an electronic device, including a packaged chip and a PCB, where the packaged chip is electrically connected to the PCB.

### BRIEF DESCRIPTION OF DRAWINGS

FIG. 1a is a schematic diagram of a wafer;
FIG. 1b is a schematic sectional view of a packaged chip;
FIG. 1c is a schematic sectional view of an electronic device;
FIG. 2 is a cross-sectional section view of a semiconductor device according to an embodiment of this application;
FIG. 3 is a cross-sectional section view of a more specific semiconductor device according to an embodiment of this application;
FIG. 4 is a cross-sectional section view of another more specific semiconductor device according to an embodiment of this application;
FIG. 5a is a section view of a cross section AA' of still another more specific semiconductor device according to an embodiment of this application; and
FIG. 5b is a section view of a cross section BB' of still another more specific semiconductor device according to an embodiment of this application.

### DESCRIPTION OF EMBODIMENTS

The following clearly and completely describes the technical solutions in embodiments of this application with reference to the accompanying drawings in embodiments of this application.

In the specification, the claims, and the accompanying drawings of this application, the terms "first", "second", "third", "fourth", and the like are intended to distinguish between different objects but do not indicate a particular order. In addition, the terms "including", "having", and any other variants thereof are intended to cover a non-exclusive inclusion. For example, a process, a method, a system, a product, or a device that includes a series of steps or units is not limited to the listed steps or units, but optionally further includes unlisted steps or units, or optionally further includes other inherent steps or units of the process, the method, the product, or the device.

"An embodiment" mentioned in this specification indicates that a particular characteristic, structure, or feature that is related to the embodiment may be included in at least one embodiment of this application. The phrase in various locations in this specification does not necessarily refer to a same embodiment, and is not an independent or alternate embodiment exclusive of another embodiment. A person skilled in the art would understand, in explicit and implicit manners, that an embodiment described in this specification may be combined with another embodiment.

A dummy circuit (dummy pattern) is also referred to as a virtual circuit, and is usually used as a circuit part that is manufactured in a chip manufacturing process and that meets an occupancy requirement in a design rule. The dummy circuit can be manufactured by using a same process as an active circuit. For example, in a case in which the active circuit is a MOS device, similar to the active circuit, the dummy circuit also includes a gate, a drain, a source, and the like. However, because the dummy circuit is not electrically connected to the active circuit, the dummy circuit is not used as a normal working circuit, that is, the dummy circuit itself has no signal processing capability, for example, signal amplification, filtering, or conversion. When the dummy circuit is manufactured, there is no need to consider whether there is a connection relationship between metal layers in the dummy circuit. Therefore, there is no need to connect the metal layers by using a structure such as a metal via, to implement electrical conduction. Generally, there is no electrical conduction between the metal layers in the dummy circuit, or there is no intentionally designed electrical conduction.

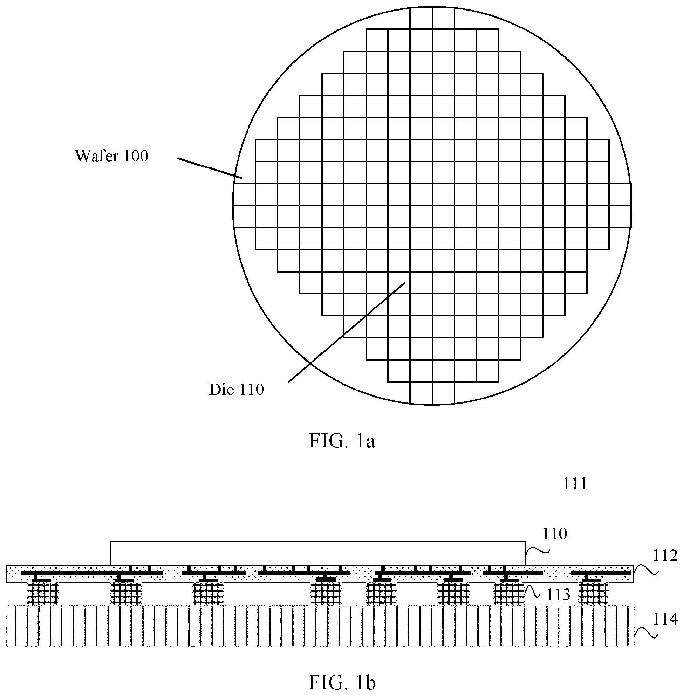

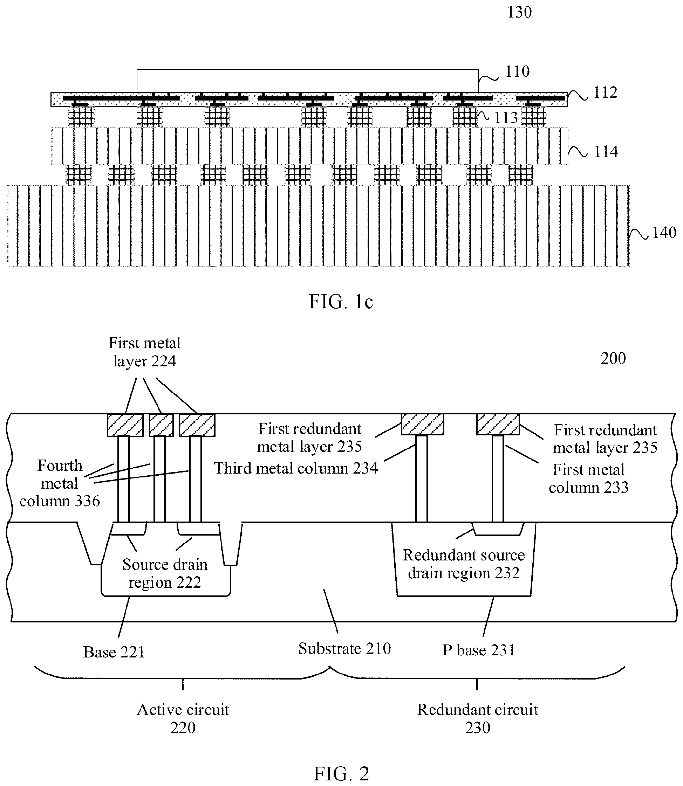

FIG. 1a is a schematic diagram of a wafer 100, including a plurality of dies (dies) 110, where each die 110 may include an independent circuit to implement a preset circuit function. In a chip manufacturing process, the wafer 100 may be cut into the plurality of dies 110, and each die 110 is packaged to obtain a packaged chip, or the wafer 100 may be first packaged and then cut to obtain the packaged chip. FIG. 1b is a schematic sectional diagram of a packaged chip 111, including a die 110, a plastic packaging (molding) material 115, and a redistribution layer (RDL) 112 and a connecting piece 113 that are disposed on a lower surface of the plastic packaging material 115. The connecting piece 113 is connected to the redistribution layer 112 and an external circuit, for example, another substrate or a printed circuit board (PCB). The connecting piece 113 may be a metal column or a solder ball. FIG. 1c is a schematic sectional diagram of an electronic device 130, including the foregoing packaged chip 111 and a PCB 140, where the packaged chip 111 is disposed on the PCB 140 and is electrically connected to the PCB 140. The foregoing die 110 may be a radio frequency (RF) chip, a memory chip, a field programmable gate array (FPGA) chip, or the like. The packaged chip 111 may be an application processor (AP) including the plurality of dies 110, may be a storage chip packaged in a stacked manner by using the plurality of dies 110, or may be a chip having another function. The foregoing electronic device 130 may be a mobile terminal such as a mobile phone or a laptop computer, or a device such as a personal computer (PC), a server, a router, or a switch.

Embodiments of this application provide a semiconductor device with a high yield rate. The semiconductor device may be the die 110 in FIG. 1a, or the die 110 in FIG. 1b, or the die 110 included in the electronic device 130 in FIG. 1c. The semiconductor device may also be understood as the foregoing packaged chip 111, or a packaged chip including more foregoing dies 110.

FIG. 2 is a cross-sectional section view of a semiconductor device 200 according to an embodiment of this application. The semiconductor device 200 includes a substrate 210, and a circuit disposed on a first side (that is, above the substrate 210 in FIG. 2) of the substrate 210, including an active circuit 220 and a dummy circuit 230. The active circuit 220 is also referred to as an active device, and includes an electronic component that requires a power supply to implement a specific function, for example, implementing signal amplification and conversion. In an implementation, the active circuit 220 may include an electron tube, a transistor, an application specific integrated circuit (ASIC), or the like. Specifically, the active circuit 220 may include an N-channel metal oxide semiconductor (NMOS) field effect transistor (FET), a P-channel metal oxide semiconductor (PMOS) field effect transistor, or a complementary metal-oxide-semiconductor (CMOS) field effect transistor. The active circuit 220 may also be a fin field effect transistor (FinFET), a tunnel field effect transistor (TFET ), or the like. That the dummy circuit and the active circuit are disposed on one side of the substrate may be understood as that each part included in the dummy circuit and the active circuit is disposed in the substrate and is close to a surface of the substrate, disposed on the surface of the substrate, or disposed on one side of the substrate but is not in direct contact with the substrate.

In the semiconductor device 200 shown in FIG. 2, a manufacturing process of the dummy circuit 230 is the same as a manufacturing process of the active circuit 220, and both of the manufacturing processes are FinFET manufacturing processes. In a possible implementation, both of the dummy circuit 230 and the active circuit 220 may be a planar device manufacturing process. In another possible implementation, two different manufacturing processes may be implemented on the semiconductor device 200, for example, a manufacturing process for a dummy circuit 230 of a FinFET and an active circuit 220 of a planar device, or a manufacturing process for a dummy circuit 230 of a planar device and an active circuit 220 of a FinFET.

The active circuit 220 of the semiconductor device 200 includes a base 221 and a source drain region 222 that are disposed in the substrate 210, a plurality of fourth metal columns 336 that are disposed on a surface of the substrate 210, and a first metal layer 224 that is connected to the plurality of the fourth metal columns 336. The dummy circuit 230 includes a lightly-doped P base 231 disposed in the substrate 210, a dummy source drain region 232, and a first metal column 233, a third metal column 234, and a first dummy metal layer 235 that are disposed on the surface of the substrate 210. One end of the first metal column 233 is connected to the first dummy metal layer 235, and the other end is connected to the dummy source drain region 232. One end of the third metal column 234 is connected to the first dummy metal layer 235, and the other end is connected to the P base 231. It should be noted that FIG. 2 shows the cross-sectional section view of the semiconductor device 200. Therefore, components of the first metal layer 224 in FIG. 2 are actually electrically connected in another sectional plane, and the first dummy metal layer 235 is also electrically connected in another sectional plane. In addition, because a source region and a drain region in the dummy circuit have no actual circuit function, the source region and the drain region in the dummy circuit are collectively referred to as the dummy source drain region, and are represented by only one region in the figure of this embodiment. A part of the active circuit 220 and a part of the dummy circuit 230 (for example, a P base and a source drain region) are disposed in the substrate 210, and other parts (for example, a gate and a metal column) are disposed on the surface of the substrate 210. In this embodiment of this application, both of the active circuit 220 and the dummy circuit 230 may be considered to be disposed on one side of the substrate 210. The P base in this embodiment of this application may also be referred to as a P-type base or a P well. Correspondingly, an N base may also be referred to as an N-type base or an N well.

The foregoing fourth metal columns 336, the first metal column 233, and the third metal column 234 may include cobalt Co or copper Cu. In an implementation, the fourth metal columns 336, the first metal column 233, and the third metal column 234 are all Co plugs or Cu plugs. Both of the metal layers and the dummy metal layers are metal cabling layers, and may include a metal copper wire or a metal cobalt wire. In addition, the metal cabling layers are insulated by using a blocking material.

The dummy circuit 230 is insulated from the active circuit 220. Specifically, the first dummy metal layer 235 and the first metal layer 224 in the dummy circuit 230 are located at a same metal layer, but the first dummy metal layer 235 is insulated from the first metal layer 224. According to the invention, the dummy source drain region 232 and the P base 231 in the dummy circuit 230 are also insulated from the source drain region 222 and the base 221 in the active circuit 220.

The dummy source drain region 232 in the dummy circuit 230 is a P-type heavily-doped region, and the P base 231 surrounding the dummy source drain region 232 is a lightly-doped region. In other words, a doping density of the dummy source drain region 232 is greater than a doping density of the P base 231. In an implementation, the doping density of the dummy source drain region 232 is 100 to 10000 times the doping density of the P base 231. In an implementation, the doping density of the P base 231 is 100 to 10000 times a doping density of the substrate 210. In an implementation, the doping density of the dummy source drain region 232 is from 10¹⁹/*cm*³ to 10²²/*cm*³. Specifically, the doping density of the dummy source drain region 232 may be from 10²⁰/*cm*³.

The semiconductor device 200 may be a wafer, a die, or a packaged chip. The metal plug in this embodiment of this application may be a metal column structure, or another metal structure, to connect metal layers at two ends of the metal plug and provide low impedance.

Because the doping density of the heavily-doped dummy source drain region 232 is greater than the doping density of the P base 231, non-directional and low-impedance resistance is formed between the dummy source drain region 232 and the P base 231. The resistance enables charges to flow from the substrate 210 to the dummy source drain region 232 through the P base 231, and then flow to the first dummy metal layer 235 through the first metal column 233. Alternatively, the resistance may enable the charges to flow in a reverse direction, that is, flow from the first dummy metal layer 235 to the dummy source drain region 232 through the first metal column 233, and finally flow to the substrate 210 through the P base 231. Because the charges may be transferred and flow in two channels in opposite directions, both positive charges and negative charges accumulated on metal conductors in the semiconductor device 200 may be transferred, so that the metal conductors and the substrate 210 are equipotential. Therefore, this can dredge the charges accumulated on the metal conductors, reduce damage caused by the charges to a circuit, and improves reliability and a yield rate of the semiconductor device 200. In addition, a structure of the dummy circuit 230 in the semiconductor device 200 is the same as a structure of a dummy circuit in the current technology. Therefore, during manufacturing of the semiconductor device 200, a production process may not need to be changed. This reduces costs.

In an implementation, the dummy source drain region 232 is heavily-doped P-type silicon Si. To improve a charge conduction effect, in another implementation, the dummy source drain region 232 may alternatively be heavily-doped P-type silicon-germanium SiGe. The heavily-doped P-type SiGe is used to further reduce impedance between the dummy source region 232 and the P base 231. This facilitates bidirectional conduction of charges.

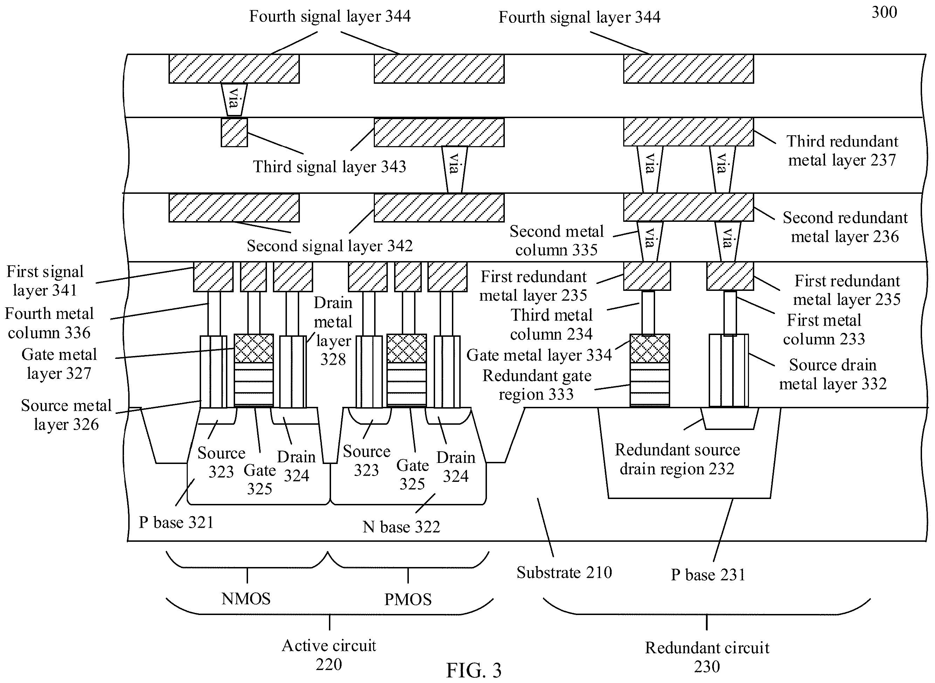

FIG. 3 is a cross-sectional section view of a more specific semiconductor device 300 according to an embodiment of this application. The semiconductor device 300 includes a substrate 210, an active circuit 230, and a dummy circuit 230. The active circuit 220 is a FinFET, and the active circuit 220 may include an NMOS device and a PMOS device. The NMOS device includes a P base 321 disposed in the substrate 210, a source 323 and a drain 324 that are located in the P base 321 and that are disposed opposite to each other, a source metal layer 326 that is disposed on a surface of the substrate 210 and that is connected to the source 323, a drain metal layer 328 that is disposed on the surface of the substrate 210 and that is in contact with the drain 324, a gate 325, and a gate metal layer 327 that is connected to the gate 325. In addition, the source metal layer 326, the gate metal layer 327, and the drain metal layer 328 in the NMOS device are separately connected to a first signal layer 341 by using a fourth metal column 336. Similarly, the PMOS device includes an N base 322 disposed in the substrate 210 and a component that is the same as the NMOS device. Details are not described herein again.

The dummy circuit 230 and the active circuit 220 may be manufactured by a same semiconductor manufacturing process. In other words, the dummy circuit 230 may include a semiconductor structure that is similar to the active circuit 220. Therefore, the dummy circuit 230 may also include a P base 231 disposed in the substrate 210 and a dummy source drain region 232 disposed in the P base 231. The P base 231 surrounds the dummy source drain region 232. The dummy circuit 230 shown in FIG. 3 may further include a source drain metal layer 332 disposed between a first metal column 233 and the dummy source flow region 232, a dummy gate region 333 and a gate metal layer 334. The dummy gate region 333 is disposed on the surface of the substrate 210 and is connected to the P base 231, and the gate metal layer 334 is disposed between a third metal column 234 and the dummy gate region 333. A first dummy metal layer 235 is insulated from the first signal layer 341. In an implementation, the first dummy metal layer 235 and the first signal layer 341 are located at a same metal layer.

In an implementation, the gate metal layer 334 may be Co or Cu, to reduce impedance between the third metal column 234 and the dummy gate region 333. In an implementation, the source drain metal layer 332 is also manufactured by using a low-impedance material, for example, Co, titanium Ti, or tungsten W.

The semiconductor device 300 may further include a plurality of metal layers. In an implementation, the semiconductor device 300 further includes a second signal layer 342 and a second dummy metal layer 236 that are located at a same layer and that are insulated from each other. The second signal layer 342 and the first signal layer 341 may or may not be electrically connected. The second dummy metal layer 236 and the first dummy metal layer 235 are electrically connected. For example, the second dummy metal layer 236 and the first dummy metal layer 235 are electrically connected in a sectional plane shown in FIG. 3 by using a second metal column 335, or may be electrically connected in another sectional plane. In an implementation, the second metal column 335 may be a metal hole (via). In an implementation, the semiconductor device 300 further includes a third signal layer 343 and a third dummy metal layer 237 that are located at a same layer and that are insulated from each other. The third signal layer 343 and the second signal layer 342 may or may not be electrically connected. The third dummy metal layer 237 and the second dummy metal layer 236 are electrically connected in a sectional plane shown in FIG. 3 by using a metal column (for example, a via), or are electrically connected in another sectional plane. The semiconductor device 300 may further include a fourth signal layer 344. The fourth signal layer 344 may be connected to the third signal layer 343 by using the via, but remains insulated from the third dummy metal layer 237. It is easy to understand that the fourth signal layer 344 is also insulated from the second dummy metal layer 236 and the first dummy metal layer 235.

The semiconductor device 300 may further include more dummy metal layers and signal layers. In an implementation, each of all the dummy metal layers in the semiconductor device 300 is electrically connected to an adjacent dummy metal layer. In an implementation, each of the foregoing dummy metal layers is connected to another dummy metal layer that is far away from the dummy metal layer by using a metal column.

The adjacent dummy metal layers are connected so that charges can be conducted between the adjacent dummy metal layers. This facilitates conduction of the charges to the substrate 210 or conduction of the charges from the substrate 210 to the dummy circuit 230.

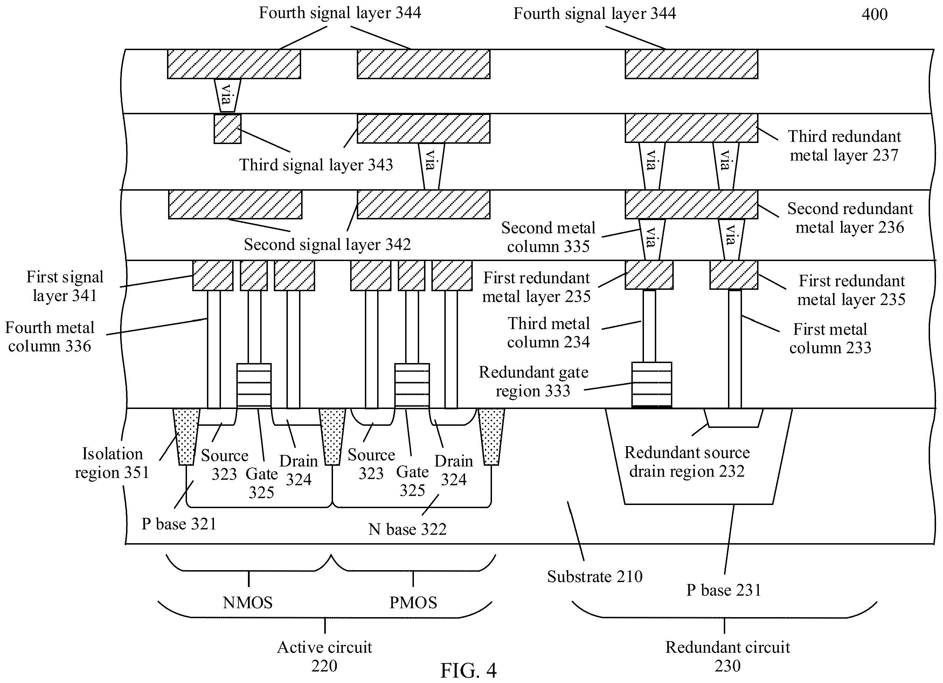

FIG. 4 is a cross-sectional section view of another more specific semiconductor device 400 according to an embodiment of this application. The semiconductor device 400 is similar to the semiconductor device 300, and components included in the semiconductor device 400 that are the same as those included in the semiconductor device 300 and connection relationships between the components are not described herein again. A difference lies in that an active circuit 220 in the semiconductor device 400 is a planar device. Specifically, a source 323 in the active circuit 220 is directly connected to a first signal layer 341 by using a fourth metal column 336. Similarly, a drain 324 in the active circuit 220 is directly connected to the first signal layer 341 by using the fourth metal column 336. In an implementation, a gate 325 is directly connected to the first signal layer 341 by using the fourth metal column 336. In addition, as shown in FIG. 4, the semiconductor device 400 further includes a plurality of isolation regions 351, disposed at a location adjacent to the source 323 or the drain 324 of the active circuit 220. The isolation regions 351 may be a shallow trench isolation (STI) region.

A dummy circuit 230 and the active circuit 220 may be manufactured by a same semiconductor manufacturing process. In other words, the dummy circuit 230 may include a semiconductor structure that is similar to the active circuit 220. Specifically, a dummy source and drain region 232 in the dummy circuit 230 is directly connected to a first dummy metal layer 235 by using a first metal column 233. Similarly, a dummy gate region 333 in the dummy circuit 230 is directly connected to the first dummy metal layer 235 by using a third metal column 234.

A plurality of dummy metal layers in the dummy circuit 230 may be connected to each other on a same cross section by using vias, or may be connected to each other on different cross sections by using the vias.

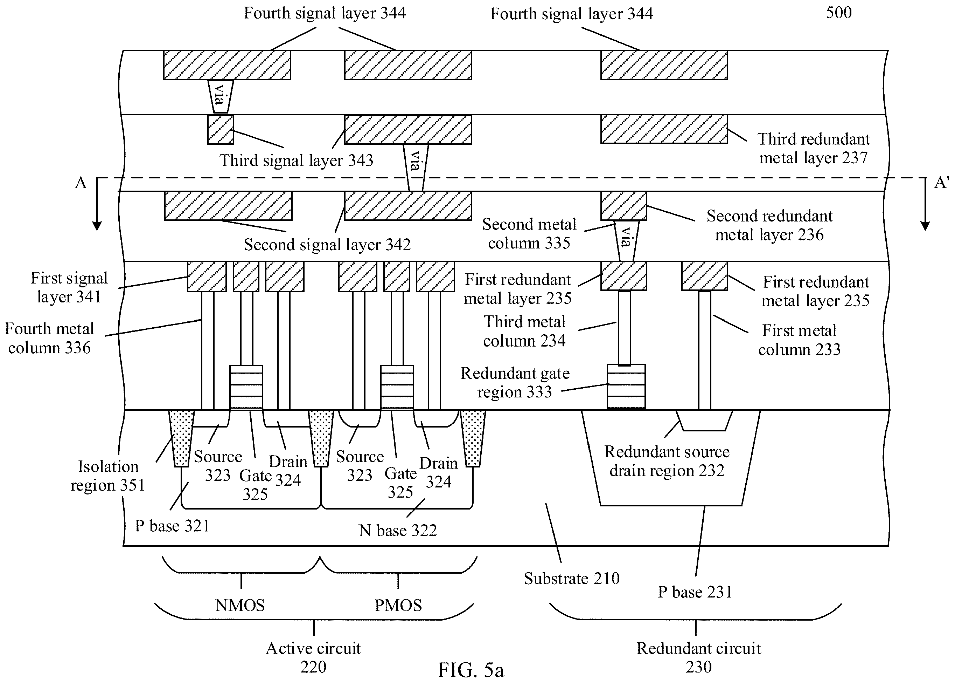

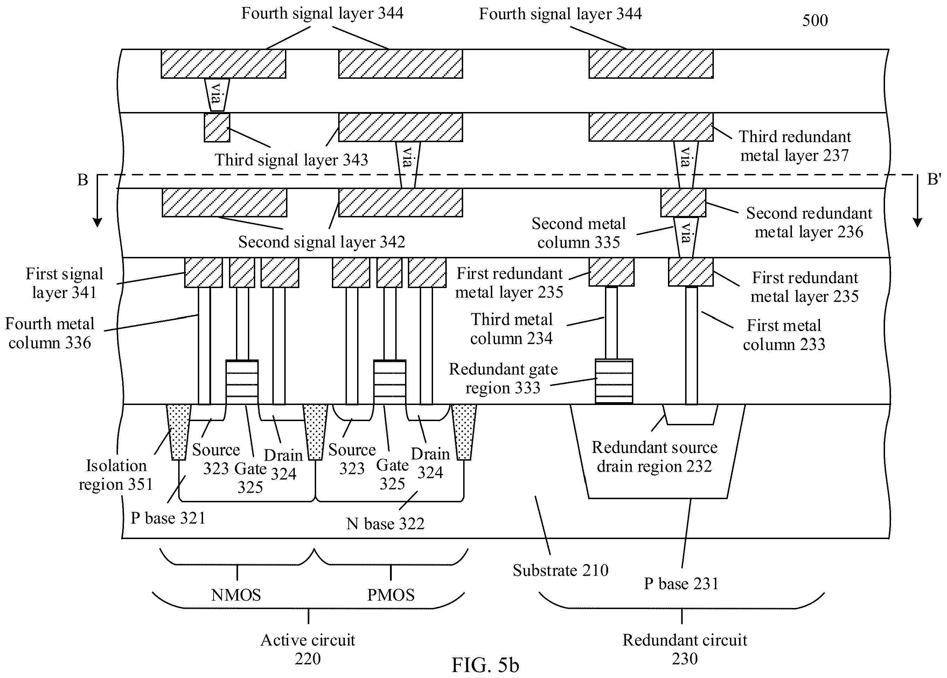

In the dummy circuits 230 of the semiconductor device 300 and the semiconductor device 400, the first dummy metal layers 235, the second dummy metal layers 236, and the third dummy metal layers 237 are all connected by using a via on a cross section shown in the figure. In an implementation, the dummy metal layers may be connected by using vias on different cross sections. FIG. 5a is a section view of a cross section AA' of still another more specific semiconductor device 500 according to an embodiment of this application. The semiconductor device 500 is similar to the semiconductor device 300, and components included in the semiconductor device 500 that are the same as those included in the semiconductor device 300 and connection relationships between the components are not described herein again. A difference lies in that, in the cross section AA', a part of a first dummy metal layer 235 connected to a third metal column 234 is directly connected to a second dummy metal layer 236 by using a second metal column 335 (for example, a via). However, the second dummy metal layer 236 is not directly connected to a third dummy metal layer 237 in the AA' cross section. FIG. 5b is a section view of a cross section BB' of the semiconductor device 500, where the cross section AA' and the cross section BB' are two cross sections of the semiconductor device 500 that are in parallel with each other and that are perpendicular to a direction of the substrate 210. In FIG. 5b, a part of a first dummy metal layer 235 connected to a first metal column 233 is connected to a second dummy metal layer 236 in the cross section BB' by using a second metal column 335 (for example, a via). The second dummy metal layer 236 is connected to a third dummy metal layer 237 in the BB' cross section by using a metal column (for example, a via). Therefore, the first dummy metal layer 235, the second dummy metal layer 236, and the third dummy metal layer 237 are conducted on different cross sections by using metal columns.

It should be noted that, in embodiments of this application, a component (or structure) is disposed between another components (or structures), on a surface, or on a side, and may be used to indicate a physical connection relationship between the component (or structure) and another components (or structures).

The foregoing description is merely a specific implementation of this application, but is not intended to limit the protection scope of this application. Therefore, the protection scope of this application shall be subject to the protection scope of the claims.

## Claims

1. A semiconductor device (200, 300, 400, 500), wherein the semiconductor device (200, 300, 400, 500) comprises:
A substrate (210),
an active circuit (220), disposed on a first side of the substrate (210) wherein the active circuit comprises a source drain region (222) and a base (221), and
a dummy circuit (230), disposed on the first side of the substrate (210) and insulated from the active circuit (220), wherein the dummy circuit (230) comprises:
a first dummy metal layer (235),
a P-typ heavily-doped dummy source drain region (232), disposed in the substrate (210),
a first metal column (233), disposed between the first dummy metal layer (235) and the P-typ heavily-doped dummy source drain region (232), and
a lightly-doped P base (231, 321), disposed in the substrate (210), and the lightly-doped P base (231, 321) surrounds the P-typ heavily-doped dummy source drain region (232), **characterized in that** the P-typ heavily-doped dummy source drain region (232) and the lightly-doped P base (231, 321) in the dummy circuit (230) are also insulated from the source drain region (222) and the base (221) in the active circuit (220).

2. The semiconductor device (200, 300, 400, 500) according to claim 1, wherein the dummy circuit (230) further comprises:
a second dummy metal layer (236), disposed on a side that is on the first dummy metal layer (235) and that is far away from the substrate (210), and
a second metal column (335), wherein the first dummy metal layer (235) and the second dummy metal layer (236) are connected by using the second metal column (335).

3. The semiconductor device (200, 300, 400, 500) according to claim 1 or 2, wherein the dummy source drain region (232) comprises heavily-doped P-type silicon-germanium, SiGe.

4. The semiconductor device (200, 300, 400, 500) according to any one of claims 1 to 3, wherein a doping density of the dummy source drain region (232) is 100 to 10000 times a doping density of the lightly-doped P base (231, 321).

5. The semiconductor device (200, 300, 400, 500) according to any one of claims 1 to 4, wherein the dummy circuit (230) further comprises:
a third metal column (234), disposed between the first dummy metal layer (235) and a dummy gate region (333),
wherein
the dummy gate region (333) is disposed between the third metal column (234) and the lightly-doped P base (231, 321).

6. The semiconductor device (200, 300, 400, 500) according to claim 5, wherein the dummy circuit (230) further comprises:
a gate metal layer (327, 334), disposed between the third metal column (234) and the dummy gate region (333), and
a source drain metal layer (332), disposed between the first metal column (233) and the dummy source drain region (232).

7. The semiconductor device (200, 300, 400, 500) according to claim 6, wherein the gate metal layer (327, 334) comprises cobalt Co or titanium Ti, and the source drain metal layer (332) comprises Co or Ti.

8. The semiconductor device (200, 300, 400, 500) according to any one of claims 5 to 7, wherein a plurality of first metal columns (233) and the third metal column (234) are cobalt Co plugs or copper Cu plugs.

9. The semiconductor device (200, 300, 400, 500) according to any one of claims 2 to 5, wherein the second metal column (335) is a metal copper via.

10. The semiconductor device (200, 300, 400, 500) according to any one of claims 1 to 9, wherein the active circuit (220) comprises a planar device or a fin field-effect transistor FinFET.

11. A packaged chip, comprising a plastic packaging material (115) and a die (110) disposed in the plastic packaging material (115), wherein the die (110) is the semiconductor device (200, 300, 400, 500) according to any one of claims 1 to 10.

12. An electronic device (130), comprising a printed circuit board, PCB (140), (140) and the packaged chip according to claim 11, wherein the PCB (140) is electrically connected to the packaged chip.

## Patentansprüche

1. Halbleitervorrichtung (200, 300, 400, 500), wobei die Halbleitervorrichtung (200, 300, 400, 500) Folgendes umfasst:
ein Substrat (210),
eine aktive Schaltung (220), die auf einer ersten Seite des Substrats (210) angeordnet ist, wobei die aktive Schaltung einen Source-Drain-Bereich (222) und eine Basis (221) umfasst, und
eine Dummy-Schaltung (230), die auf der ersten Seite des Substrats (210) angeordnet und von der aktiven Schaltung (220) isoliert ist, wobei die Dummy-Schaltung (230) Folgendes umfasst:
eine erste Dummy-Metallschicht (235),
einen stark dotierten Dummy-Source-Drain-Bereich (232) einer P-Art, der in dem Substrat (210) angeordnet ist,
eine erste Metallsäule (233), die zwischen der ersten Dummy-Metallschicht (235) und dem stark dotierten Dummy-Source-Drain-Bereich (232) der P-Art angeordnet ist, und
eine schwach dotierte P-Basis (231, 321), die in dem Substrat (210) angeordnet ist, und wobei die schwach dotierte P-Basis (231, 321) den stark dotierten Dummy-Source-Drain-Bereich (232) der P-Art umschließt, **dadurch gekennzeichnet, dass** der stark dotierte Dummy-Source-Drain-Bereich (232) der P-Art und die schwach dotierte P-Basis (231, 321) in der Dummy-Schaltung (230) ebenfalls von dem Source-Drain-Bereich (222) und der Basis (221) in der aktiven Schaltung (220) isoliert sind.

2. Halbleitervorrichtung (200, 300, 400, 500) nach Anspruch 1, wobei die Dummy-Schaltung (230) ferner Folgendes umfasst:
eine zweite Dummy-Metallschicht (236), die auf einer Seite angeordnet ist, die auf der ersten Dummy-Metallschicht (235) liegt und die weit von dem Substrat (210) entfernt ist, und
eine zweite Metallsäule (335), wobei die erste Dummy-Metallschicht (235) und die zweite Dummy-Metallschicht (236) unter Verwendung der zweiten Metallsäule (335) miteinander verbunden sind.

3. Halbleitervorrichtung (200, 300, 400, 500) nach Anspruch 1 oder 2, wobei der Dummy-Source-Drain-Bereich (232) stark dotiertes Silizium-Germanium, SiGe, der P-Art umfasst.

4. Halbleitervorrichtung (200, 300, 400, 500) nach einem der Ansprüche 1 bis 3, wobei eine Dotierungsdichte des Dummy-Source-Drain-Bereichs (232) 100- bis 10000-mal eine Dotierungsdichte der schwach dotierten P-Basis (231, 321) beträgt.

5. Halbleitervorrichtung (200, 300, 400, 500) nach einem der Ansprüche 1 bis 4, wobei die Dummy-Schaltung (230) ferner Folgendes umfasst:
eine dritte Metallsäule (234), die zwischen der ersten Dummy-Metallschicht (235) und einem Dummy-Gate-Bereich (333) angeordnet ist, wobei
der Dummy-Gate-Bereich (333) zwischen der dritten Metallsäule (234) und der schwach dotierten P-Basis (231, 321) angeordnet ist.

6. Halbleitervorrichtung (200, 300, 400, 500) nach Anspruch 5, wobei die Dummy-Schaltung (230) ferner Folgendes umfasst:
eine Gate-Metallschicht (327, 334), die zwischen der dritten Metallsäule (234) und dem Dummy-Gate-Bereich (333) angeordnet ist, und
eine Source-Drain-Metallschicht (332), die zwischen der ersten Metallsäule (233) und dem Dummy-Source-Drain-Bereich (232) angeordnet ist.

7. Halbleitervorrichtung (200, 300, 400, 500) nach Anspruch 6, wobei die Gate-Metallschicht (327, 334) Kobalt, Co, oder Titan, Ti, umfasst und die Source-Drain-Metallschicht (332) Co oder Ti umfasst.

8. Halbleitervorrichtung (200, 300, 400, 500) nach einem der Ansprüche 5 bis 7, wobei eine Vielzahl erster Metallsäulen (233) und die dritte Metallsäule (234) Kobalt-Stecker, Co-Stecker, oder Kupfer-Stecker, Cu-Stecker, sind.

9. Halbleitervorrichtung (200, 300, 400, 500) nach einem der Ansprüche 2 bis 5, wobei die zweite Metallsäule (335) eine Metall-Kupfer-Durchkontaktierung ist.

10. Halbleitervorrichtung (200, 300, 400, 500) nach einem der Ansprüche 1 bis 9, wobei die aktive Schaltung (220) eine planare Vorrichtung oder einen Fin-Feldeffekttransistor, FinFET, umfasst.

11. Verpackter Chip, umfassend ein Kunststoffverpackungsmaterial (115) und eine Matrize (110), die in dem Kunststoffverpackungsmaterial (115) angeordnet ist, wobei die Matrize (110) die Halbleitervorrichtung (200, 300, 400, 500) nach einem der Ansprüche 1 bis 10 ist.

12. Elektronische Vorrichtung (130), umfassend eine Leiterplatte, PCB (140), (140) und den verpackten Chip nach Anspruch 11, wobei die PCB (140) elektrisch mit dem verpackten Chip verbunden ist.

## Revendications

1. Dispositif à semi-conducteur (200, 300, 400, 500), dans lequel le dispositif à semi-conducteur (200, 300, 400, 500) comprend :
un substrat (210),
un circuit actif (220), disposé sur un premier côté du substrat (210), dans lequel le circuit actif comprend une région source-drain (222) et une base (221), et
un circuit factice (230), disposé sur le premier côté du substrat (210) et isolé du circuit actif (220), dans lequel le circuit factice (230) comprend :
une première couche métallique factice (235),
une région source-drain factice fortement dopée de type P (232), disposée dans le substrat (210),
une première colonne métallique (233), disposée entre la première couche métallique factice (235) et la région source-drain factice fortement dopée de type P (232), et
une base P légèrement dopée (231, 321), disposée dans le substrat (210), et la base P légèrement dopée (231, 321) entoure la région source-drain factice fortement dopée de type P (232),
**caractérisée en ce que** la région source-drain factice fortement dopée de type P (232) et la base P légèrement dopée (231, 321) dans le circuit factice (230) sont également isolées de la région source-drain (222) et de la base (221) dans le circuit actif (220).

2. Dispositif à semi-conducteur (200, 300, 400, 500) selon la revendication 1, dans lequel le circuit factice (230) comprend en outre :
une seconde couche métallique factice (236), disposée sur un côté qui se trouve sur la première couche métallique factice (235) et qui est éloignée du substrat (210), et
une deuxième colonne métallique (335), dans lequel la première couche métallique factice (235) et la seconde couche métallique factice (236) sont connectées à l'aide de la deuxième colonne métallique (335).

3. Dispositif à semi-conducteur (200, 300, 400, 500) selon la revendication 1 ou 2, dans lequel la région source-drain factice (232) comprend du silicium-germanium, SiGe, de type P fortement dopé.

4. Dispositif à semi-conducteur (200, 300, 400, 500) selon l'une quelconque des revendications 1 à 3, dans lequel une densité de dopage de la région source-drain factice (232) est de 100 à 10 000 fois une densité de dopage de la base P légèrement dopée (231, 321).

5. Dispositif à semi-conducteur (200, 300, 400, 500) selon l'une quelconque des revendications 1 à 4, dans lequel le circuit factice (230) comprend en outre :
une troisième colonne métallique (234), disposée entre la première couche métallique factice (235) et une région de grille factice (333), dans lequel
la région de grille factice (333) est disposée entre la troisième colonne métallique (234) et la base P légèrement dopée (231, 321).

6. Dispositif à semi-conducteur (200, 300, 400, 500) selon la revendication 5, dans lequel le circuit factice (230) comprend en outre :
une couche métallique de grille (327, 334), disposée entre la troisième colonne métallique (234) et la région de grille factice (333), et
une couche métallique source-drain (332), disposée entre la première colonne métallique (233) et la région source-drain factice (232).

7. Dispositif à semi-conducteur (200, 300, 400, 500) selon la revendication 6, dans lequel la couche métallique de grille (327, 334) comprend du cobalt Co ou du titane Ti, et la couche métallique source-drain (332) comprend du Co ou du Ti.

8. Dispositif à semi-conducteur (200, 300, 400, 500) selon l'une quelconque des revendications 5 à 7, dans lequel une pluralité de premières colonnes métalliques (233) et la troisième colonne métallique (234) sont des bouchons en cobalt Co ou des bouchons en cuivre Cu.

9. Dispositif à semi-conducteur (200, 300, 400, 500) selon l'une quelconque des revendications 2 à 5, dans lequel la deuxième colonne métallique (335) est un via en cuivre métallique.

10. Dispositif à semi-conducteur (200, 300, 400, 500) selon l'une quelconque des revendications 1 à 9, dans lequel le circuit actif (220) comprend un dispositif planaire ou un transistor à effet de champ à ailettes FinFET.

11. Puce encapsulée, comprenant un matériau d'emballage plastique (115) et une matrice (110) disposée dans le matériau d'emballage plastique (115), dans laquelle la matrice (110) est le dispositif à semi-conducteur (200, 300, 400, 500) selon l'une quelconque des revendications 1 à 10.

12. Dispositif électronique (130), comprenant une carte de circuit imprimé, PCB (140), (140) et la puce encapsulée selon la revendication 11, dans lequel la PCB (140) est connectée électriquement à la puce encapsulée.
